# EUROPEAN PATENT APPLICATION

(11) **EP 3 926 827 A1**
(43) Date of publication of application: **22.12.2021**
(21) Application number: 20180796.3
(22) Date of filing: 18.06.2020
(51) Int. Cl.: H03G 3/30, H03F 3/72, H04B 10/69

(54) **VARIABLE GAIN AMPLIFIER SYSTEM, PARTICULARLY FOR OPTICAL RECEIVER SYSTEMS**

(71) Applicant: Renesas Electronics America Inc., Milpitas, California 95035 (US)
(72) Inventor: CONVERS, Philippe, 8712 Stäfa (CH)
(74) Representative: Lippert Stachow Patentanwälte Rechtsanwälte Partnerschaft mbB

(57) **Abstract**

The invention relates to a variable gain system (1), particularly for optical receiver systems, comprising:
an input (2) for an electronic signal,
at least two variable gain amplifiers (3, 4), and
an output (5) for an amplified electrical signal,
wherein the at least two variable gain amplifiers (3, 4) are connected in parallel to the input (2) and the output (5) aggregates the signals of the at least two variable gain amplifiers (3, 4).

## Description

The invention relates to a variable gain amplifier system, particularly for optical receiver systems.

The main application of the variable gain amplifier is in transimpedance amplifier of receivers used in fiber optics communications. In these systems, a photodiode receives a data signal from an optical fiber. The signal is then amplified by the transimpedance amplifier that includes the variable gain amplifier system. The amplified signal is afterwards used in e.g. a and data (CRD) circuit. The data transmitted through the optical fiber can use different modulation, like NRZ, PAM4 or QAM. Typical data rates of state-of-the-art systems are 28 Gb, 32 Gb, 56 Gb, 64 Gb or 96 Gb. For example, a 96 Gb system requires a 60 GHz system bandwidth.

A variable gain amplifier (VGA)can be used to amplify weak and strong signals at the same time. A variable gain amplifier is an electronic amplifier that varies its gain depending on the power of the input signal. The variable gain amplifier is for example controlled by a voltage and also referred to as voltage-controlled amplifier. There are two main types of variable gain amplifiers, namely with continuous gain control and discrete gain control.

The typical circuit for a continuous gain control is a so-called Gilbert cell. The drawbacks of such a structure are relatively high noise and total harmonic distortion (THD). Discrete or switched variable gain amplifiers solve the problem of high noise and total harmonic distortion but the gain adjustment is only performed in steps. In optical receivers, a switched variable gain amplifier would need to have many small steps, because the gain has to adjust dynamically for the input power, and big gain steps could create a temporary loss of data. Many steps require many switches that will limit the system bandwidth and might not be possible for 96GB applications.

It is therefore an object of the present invention to provide a variable gain amplifier system having a continuous variable gain with low noise and total harmonic distortion.

The object is solved by a variable gain system, particularly for optical receiver systems, comprising:
an input for an electronic signal,
at least two variable gain amplifiers, and
an output for an amplified electrical signal,
wherein the at least two variable gain amplifiers (3, 4) are connected in parallel to the input (2) and the output (5) aggregates the signals of the at least two variable gain amplifiers (3, 4).

According to the invention two or more variable gain amplifiers are connected in parallel to the input and the output of the variable gain amplifier system is an aggregation of the amplified signals of the two or more variable gain amplifiers. Although the variable gain amplifier system according to the invention comprises at least two variable gain amplifiers the noise and total harmonic distortion corresponds to a variable gain system with one variable gain amplifier.

In a preferred variant of the invention the at least two variable gain amplifiers cover different portions of the gain range of the variable gain amplifier system. If the input signal power is high only the variable gain amplifier with a lower gain is active and if the input signal power is low the variable gain amplifier with a higher gain is also active. Thus, depending on the power of the input signal the variable gain amplifiers providing different gains to the input signal are activated or deactivated.

According to the invention the power at the input and/or output of the variable gain amplifier can be determined by the amplitude of the signal at the input and/or output of the variable gain amplifier.

Pursuant to a further variant of the invention the variable gain amplifier covering the lowest gain range of the variable gain amplifier system is directly connected to the output and wherein the other variable gain amplifiers covering higher gain ranges of the variable gain amplifier system are connected to the output by separate switches. Alternatively all variable gain amplifiers are connected to the output by separate switches. Thus, the variable gain amplifier providing the lowest gain for the input signal is always connected to the output of the variable gain amplifier system. The further variable gain amplifiers are subsequentially connected to the output of the variable gain amplifier system if the power of the input signal degrades. This is achieved e.g. by providing switches between the further variable gain amplifiers and the output of the variable gain amplifier system.

According to a variant of the invention the separate switches are operated by a control unit of the variable gain amplifier system based on the power of the electrical signal at the input or output of the variable gain amplifier system. The control unit monitors the power level of the electrical signal at the input or output of the variable gain amplifier system and activates or deactivates the separate switches to connect or disconnect the further variable gain amplifiers to or from the output of the variable gain amplifier system. If the switches are operated based on the power of the electrical signal at the output of the variable gain amplifier, this corresponds to a feedback structure providing an automatic gain control.

In a preferred variant of the invention the at least two variable gain amplifiers are continuous variable gain amplifiers. According to a further variant of the invention the electrical signal at the input of the variable gain amplifier system is an analog electrical signal.

In the following the invention will be further explained with respect to the embodiments shown in the figures. It shows:
- Fig. 1: a first embodiment of a variable gain amplifier system according to the invention with two variable gain amplifiers, and
- Fig. 2: a second embodiment of a variable gain amplifier system according to the invention with three variable gain amplifiers and a control unit.

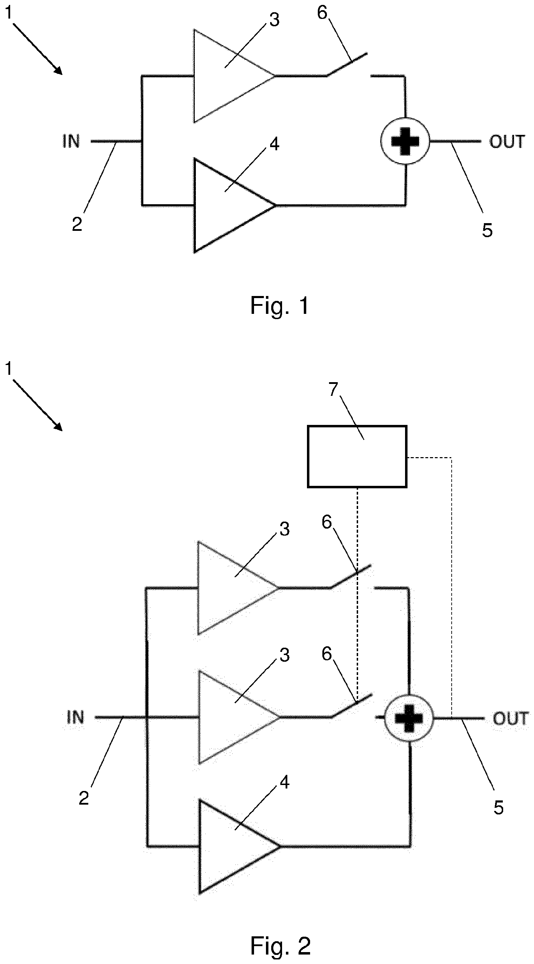

Fig. 1 shows a first embodiment of a variable gain system 1, particularly for optical receiver systems. The variable gain system 1 of Fig. 1 comprises an input 2 for an electronic signal, two variable gain amplifiers 3, 4 and an output 5 for an amplified electrical signal. The two variable gain amplifiers 3, 4 are connected in parallel to the input 2. The output 5 aggregates the signals of the two variable gain amplifiers 3, 4.

The two variable gain amplifiers 3, 4 cover different portions of the gain range of the variable gain amplifier system 1. Thus, the two variable gain amplifiers amplify different parts of the signal at the input 2 of the variable gain system 1. The variable gain amplifier 4 covering the lowest gain range of the variable gain amplifier system 1 is directly connected to the output 5 and the other variable gain amplifier 3 covering higher gain ranges of the variable gain amplifier system 1 is connected to the output 5 by separate switches 6. If the signal at the input 2 of the variable gain system 1 has a high power level only variable gain amplifier 4 is connected to the output 5 and variable gain amplifier 3 is disconnected from the output 5 by switch 6. Since the variable gain amplifier 4 covers the lower gain range of the variable gain system 1 the amplification of signal at the input 2 is limited and a saturated output signal is avoided. If the power level of the signal at the input 2 of the variable gain system 1 is low the signal is amplified by variable gain amplifier 3 and variable gain amplifier 4 and thereby amplifying the input signal stronger.

The two variable gain amplifiers 3, 4 are continuous variable gain amplifiers and the electrical signal at the input 2 is an analog electrical signal.

Since the variable gain amplifiers 3, 4 are connected in parallel to the input 2 of the variable gain system 1 the noise and total harmonic distortion corresponds to a variable gain system with one variable gain amplifier.

Fig. 2 shows a second embodiment of a variable gain system 1, particularly for optical receiver systems. The variable gain system 1 of Fig. 2 comprises an input 2 for an electronic signal, three variable gain amplifiers 3, 4 and an output 5 for an amplified electrical signal. The three variable gain amplifiers 3, 4 are connected in parallel to the input 2. The output 5 aggregates the signals of the three variable gain amplifiers 3, 4.

The three variable gain amplifiers 3, 4 cover different portions of the gain range of the variable gain amplifier system 1. The variable gain amplifier 4 covering the lowest gain range of the variable gain amplifier system 1 is directly connected to the output 5. The other two variable gain amplifiers 3 covering higher gain ranges of the variable gain amplifier system 1 are connected to the output 5 by separate switches 6.

The separate switches 6 are operated by a control unit 7 of the variable gain amplifier system 1 based on the power of the electrical signal at the output 5 of the variable gain amplifier system 1. The control unit 7 monitors the power level of the electrical signal at the output 5 of the variable gain system 1 of Fig. 2, which is indicated in Fig. 2 by dashed line between the control unit 2 and the output 5. Depending on the power level of the electrical signal at the output 5 of the variable gain system 1 the control unit 7 connects the second and/or third variable gain amplifier 3 to the output 5 using switches 6. The switches 6 are operated by control unit 7, indicated in Fig. 2 by a dashed line between control unit 7 and switches 6.

If the signal at the output 5 of the variable gain system 1 has a high power level only variable gain amplifier 4 is connected to the output 5 and the other two variable gain amplifiers 3 are disconnected from the output 5 by switches 6. Since the variable gain amplifier 4 covers the lower gain range of the variable gain system 1 the amplification of signal at the input 2 is limited and a saturated output signal is avoided. If the power level of the signal at the output 5 of the variable gain system 1 decreases the control unit 7 can close one or both switches 6 to connect one of or both variable gain amplifiers 3 to the output 5. In this case the electrical signal at the input 2 is amplified by one or both additional variable gain amplifiers 3 and variable gain amplifier 4 and thereby amplifying the input signal stronger. By increasing the number of the additional variable gain amplifiers 3 the gain range of the variable gain system 1 is increased, but the noise and total harmonic distortion still corresponds to a variable gain system 1 with one variable gain amplifier.

### List of numerals

- 1: variable gain system
- 2: input
- 3: variable gain amplifier
- 4: variable gain amplifier
- 5: output
- 6: switch
- 7: control unit

## Claims

1. Variable gain system (1), particularly for optical receiver systems, comprising:
an input (2) for an electronic signal,
at least two variable gain amplifiers (3, 4), and
an output (5) for an amplified electrical signal,
wherein the at least two variable gain amplifiers (3, 4) are connected in parallel to the input (2) and the output (5) aggregates the signals of the at least two variable gain amplifiers (3, 4).

2. Variable gain system (1) according to claim 1,
wherein the at least two variable gain amplifiers (3, 4) cover different portions of the gain range of the variable gain amplifier system (1).

3. Variable gain system (1) according to claim 2,
wherein the variable gain amplifier (4) covering the lowest gain range of the variable gain amplifier system
(1) is directly connected to the output (5) and wherein the other variable gain amplifiers (3) covering higher gain ranges of the variable gain amplifier system (1) are connected to the output (5) by separate switches (6) or wherein all variable gain amplifiers (4) are connected to the output (5) by separate switches (6).

4. Variable gain system (1) according to claim 3,
wherein the separate switches (6) are operated by a control unit (7) of the variable gain amplifier system (1) based on the power of the electrical signal at the input (2) or output (5) of the variable gain amplifier system (1) .

5. Variable gain system (1) according to any of claims 1 to 4,
wherein the at least two variable gain amplifiers (3, 4) are continuous variable gain amplifiers.

6. Variable gain system (1) according to any of claims 1 to 5,
wherein the electrical signal at the input (2) is an analog electrical signal.
